# EUROPEAN PATENT SPECIFICATION

(11) **EP 3 739 635 B1**
(45) Date of publication and mention of the grant of the patent: **09.03.2022**
(21) Application number: 20177053.4
(22) Date of filing: 30.06.2010
(51) Int. Cl.: H01L 29/41, H01S 5/026, H01S 5/042, H01L 33/38

(54) **A DEVICE COMPRISING AN ACTIVE COMPONENT AND ASSOCIATED ELECTRODES AND A METHOD OF MANUFACTURING SUCH DEVICE**
VORRICHTUNG MIT EINER AKTIVEN KOMPONENTE UND ZUGEHÖRIGE ELEKTRODEN SOWIE VERFAHREN ZUR HERSTELLUNG SOLCH EINER VORRICHTUNG
DISPOSITIF COMPRENANT UN COMPOSANT ACTIF ET ÉLECTRODES ASSOCIÉES ET PROCÉDÉ DE FABRICATION DUDIT DISPOSITIF

(43) Date of publication of application: 18.11.2020
(62) Divisional of application: 10290366.3
(73) Proprietor: Alcatel Lucent, 91620 Nozay (FR)
(72) Inventor: JANY, Christophe, 77300 FONTAINEBLEAU (FR); ALEXANDRE, François, 94400 Vitry (FR)
(74) Representative: Nokia EPO representatives

(56) References cited:
- EP-A1- 0 795 910
- US-A1- 2005 275 053

## Description

The present invention relates to devices comprising at least one integrated active component.

One means here by "active component" a component, possibly of the optoelectronic type, which requires energy to operate (voltage or current). So, it may be a laser (or active lasing medium), or a modulator, or a photodetector or else an amplifier, possibly of the SOA type ("semiconductor optical amplifier").

Data traffic is increasing in communication networks, and therefore there is a strong demand of (opto)electronic devices capable of supporting very high bit rate operations (typically greater than 40 Gb/s, and if possible at least equal to 100 Gb/s). This is notably the case of Tx/Rx ("transmitting/receiving") interfaces.

To reach such bit rates, the (opto)electronic devices must have a very low electrical capacitance C. This results from the fact that the electrical capacitance C and the bandwidth BW are linked by the formula: BW = 1 / (2 × *π* × R × C), where R is the fixed load resistance to which may be connected an (opto)electronic device (typically R is equal to 50 ohms). R being fixed, a low (R × C) value can therefore be only achieved by reducing the electrical capacitance C. Such a capacitance reduction could be achieved by reducing the device size. But this approach increases the impact of the parasite capacitance and leakage current inside certain devices (such as diode optical devices, for instance) and of the parasite capacitance and leakage current coming from their substrates.

To limit the additional capacitance that results from an assembly of hybrid components, it is possible to define several components on the same semiconductor substrate. This is notably what is done to produce the socalled photonic integrated circuits (or PIC). But in such devices high rate operations are still often disturbed by parasitic capacitance and leakage current between integrated components because they are not electrically isolated one from the other.

To improve the situation it is possible to define the active components on semi-insulating substrate, because this facilitates component electrical isolation and reduces capacitance in interconnections and bonding pads, and in the same time the electrical crosstalk between components can be eliminated. Several technologies using semi-insulating substrates have been proposed.

This is notably the case of the Diode Ridge technology. Unfortunately, this technology leads to a rather high access resistance and a rather high thermal resistance.

This is also the case of the Buried Ridge Strip (or (BRS) technology. Unfortunately, this technology leads to a rather high capacitance.

US 2005/275053 A1 discloses integrated optical components on a semiconductor substrate. Ions are implanted in one isolation region so as to sufficiently raise the isolation resistance between the integrated components.

So the object of this invention is to improve the situation to allow production of devices supporting effectively very high bit rates.

For this purpose, some embodiments of the invention provide a device comprising at least one active component (Ci), said active component being monolithically integrated onto said semi-insulating substrate (SIS), characterized in that said device further comprises at least one electrode arrangement (Eij) intended for controlling said component (Ci) by means of a control current or a control voltage, wherein the electrode arrangement includes a control electrode and a ground electrode.

By controlling the active component using a control current or control voltage parasitic capacitance may be eliminated or substantially reduced to negligible or acceptable values.

According to some specific embodiments, the ground electrode is located on the structure of the device at a position which is offset from a position directly opposite to a position of the control electrode on the structure of the device.

According to some specific embodiments, each active component is a semi-insulating buried heterostructure.

According to some specific embodiments the substrate is an Indium Phosphide semi-insulating substrate or a semi-insulating layer.

Some embodiments of the invention provide a method of manufacturing at least one active component onto a semi-insulating substrate , comprising the steps of:
∘ growing a highly N doped layer on the semi-insulating substrate, and then layers defining a vertical structure on this highly N doped layer,
∘ etching each vertical structure to define at least one etched vertical structure set on top of a remaining part of the highly N doped layer L1 and an associated ground area also with a remaining part of the highly N doped layer,
∘ growing a semi-insulating layer on the semi-insulating substrate and on each ground area and around each etched vertical structure,
∘ growing a highly P doped layer on this semi-insulating layer and on top of each etched vertical structure,
∘ etching around each etched vertical structure till the level of the highly N doped layer, to define a mesa strip constituting an active component and to clear the top of each part of this highly N doped layer defining a ground area associated to this mesa strip, and
∘ depositing a contact layer on top of a part of each ground area to define an integrated ground electrode and at least a part of another contact layer on top of a part of each mesa strip so as to define an integrated control electrode intended to allow specific control of the active component constituted by this mesa strip;

➢ one may deposit a contact layer on top of each part of the highly P doped layer set on top of an etched vertical structure, to define at least a part of the integrated control electrode that is associated to the active component constituted by an etched vertical structure, before etching around each etched vertical structure;
➢ in a variant, one may deposit the other contact layer on top of a part of each mesa strip to fully define the integrated control electrode;
➢ an insulation layer may be grown on top of each cleared part of the highly N doped layer that is located on a side of a mesa strip, before defining at least each associated integrated ground electrode;
   - the insulation layer may be a benzo-cyclo-butene (or BCB) polymer;
➢ one may use an etching technique which is chosen from a group comprising at least reactive ion etching (or RIE), ion beam etching (or IBE), inductive coupled plasma etching (or ICPE) and dry etching;
➢ in the case where at least two etched vertical structures have been defined, one may proceed to a local electrical isolation of these etched vertical structures;
   - the local electrical isolation may be carried out by means of a proton implantation in a part of at least each area that is located between the etched vertical structures.

In some specific embodiments, the device may comprise at least one integrated active component chosen from a group comprising at least a laser, a modulator, a photodetector or an amplifier (possibly of the SOA type).

It is to be noted that the control electrode referred to herein may also be a polarization electrode used in the device for polarization purposes.

Other features and advantages of the invention will become apparent on examining the detailed specifications hereafter and the appended drawings, wherein:
- figure 1 schematically illustrates a top view of an example of embodiment of a device, after implementation of a first step of an example of method according to the invention
- figure 2 schematically illustrates a cross section view along line II-II of the device of figure 1,
- figure 3 schematically illustrates a top view of the device after implementation of a second step of the example of method according to the invention,
- figures 4 and 5 schematically illustrate cross section views respectively along lines IV-IV and V-V of the device of figure 3,
- figure 6 schematically illustrates a top view of the device after implementation of third and fourth steps of the example of method according to the invention,
- figures 7 and 8 schematically illustrate cross section views respectively along lines VII-VII and VIII-VIII of the device of figure 6,
- figure 9 schematically illustrates a top view of the device after implementation of optional sub-steps of a fifth step of the example of method according to the invention,
- figures 10 and 11 schematically illustrate cross section views respectively along lines X-X and XI-XI of the device of figure 9,
- figure 12 schematically illustrates a top view of the device after implementation of a fifth step of the example of method according to the invention,
- figures 13 and 14 schematically illustrate cross section views respectively along lines XIII-XIII and XIV-XIV of the device of figure 12,
- figure 15 schematically illustrates a top view of the device after implementation of a sixth step of the example of method according to the invention, and
- figures 16 and 17 schematically illustrate cross section views respectively along lines XVI-XVI and XVII-XVII of the device of figure 15.

The appended drawings may serve not only to complete the invention, but also to contribute to its definition, if need be.

The invention aims at providing a method which is intended for defining at least one active component Ci onto a semi-insulating substrate SIS to produce a device D, of the electronic type or of the optoelectronic type.

For instance, the semi-insulating substrate SIS is made of Indium Phosphide (InP). For instance, it can be made of InP doped with Fe or Ru, or of InP doped with a conducting material, such as Si or S or Zn, with also a surface layer of semi-insulating InP. But, other types of material based on semiconductors may be used.

The method according to the invention relates to defining onto a semi-insulating substrate SIS (for instance in InP), by monolithic integration, at least one active component Ci with at least one control electrode Eij intended for specifically controlling this active component Ci by means of control current or control voltage.

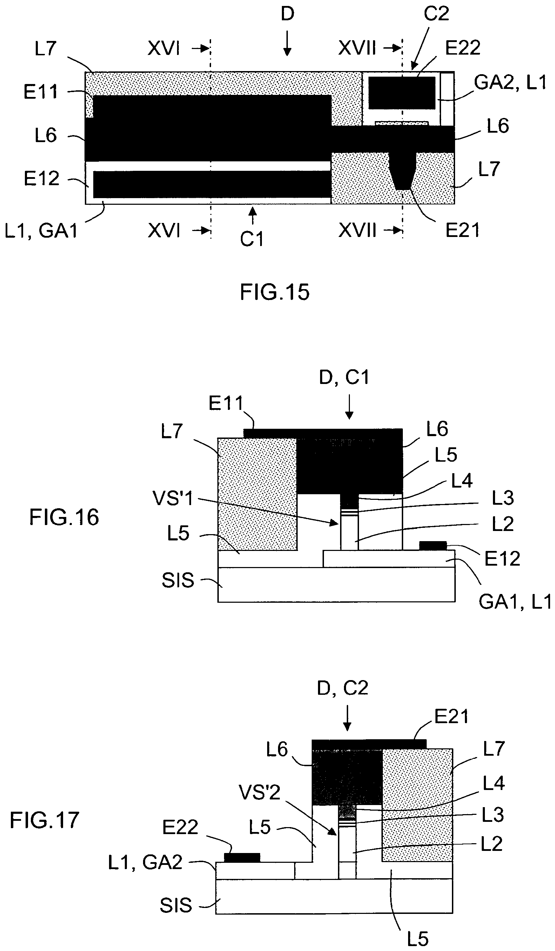

In the following description, it will be considered, as example, that the method is implemented in order to define two active components Ci (i = 1 or 2) with their respective electrodes Eij on a semi-insulating substrate SIS and therefore produce a two component device D, such as the one illustrated in figures 15-17.

It is important to note that the device D illustrated in figures 15-17 comprises a first active component C1 which constitutes a laser (or active lasing medium) and a second active component C2 which constitutes a modulator. But, the invention is not limited to the production of this type of device D. Indeed, it may comprise one active component, possibly coupled to integrated passive component(s), or two or more active components coupled together, and possibly coupled to integrated passive component(s). So, a device D according to the invention may comprise a laser and/or a modulator and/or a photodetector and/or an amplifier, possibly of the SOA type ("semiconductor optical amplifier"), for instance.

In the following description, it will be considered, as example, that each active component Ci is a semi-insulating buried heterostructure (or SIBH). But, this is not mandatory.

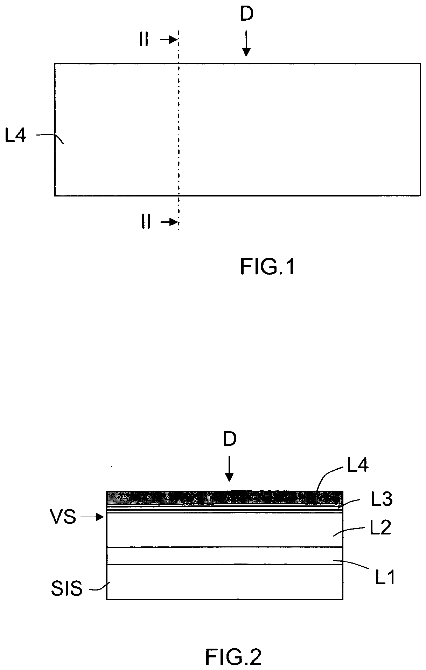

A detailed, but not limiting, example of the method according to the invention is described hereafter with reference to figures 1-17.

This example of method comprises at least six steps.

A first step comprises growing a highly N doped layer L1 on a semi-insulating substrate SIS, and then layers L2-L4, which define together a vertical structure VS, on this highly N doped layer L1. The result of the implementation of this first step is illustrated in figures 1 and 2.

In the case where the components to define are a laser C1 and a modulator C2, the vertical structure VS may comprise a N doped layer L2, an intrinsic layer L3 defining a waveguide, and a P doped layer L4.

This first step can be done by means of an epitaxy.

In the case where the semi-insulating substrate SIS is made of InP, the highly N doped layer L1 can be also made of InP (InP-N+), layer L2 can be made of N doped InP, layer L3 can be made of quaternary semiconductors (such as GaInAsP (Gallium Indium Arsenide Phosphide)) or of quantum wells (for instance made of sub-layers of Aluminium or Phosphorus), and layer L4 can be made of P doped InP.

But other combinations of layers and/or material, known by the person skilled in the art, could be used, notably to define other type of components.

A second step comprises etching the vertical structure VS (defined in the first step) in order to define at least one etched vertical structure VS'i set on top of a remaining part of the highly N doped layer L1 and an associated ground area GAi also with a remaining part of the highly N doped layer L1 (possibly the same than the one of the etched vertical structure VS'i).

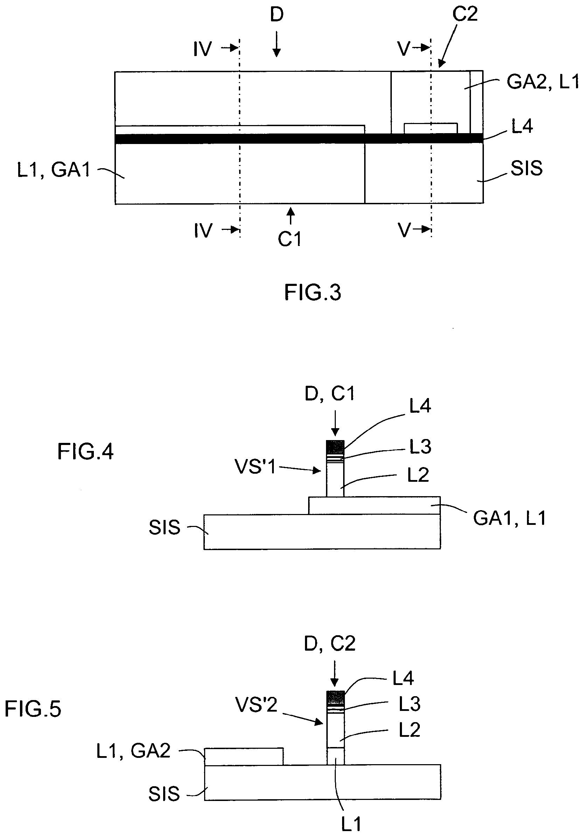

The result of the implementation of this second step is illustrated in figures 3-5.

In the case where the components to define are a laser C1 and a modulator C2, the etching aims at defining a first etched vertical structure VS'1 on top of a first remaining part of the highly N doped layer L1 and an associated first ground area GA1 with the same remaining part of the highly N doped layer L1, a second etched vertical structure VS'2 on top of a second remaining part of the highly N doped layer L1 and a second ground area GA2 with a third remaining part of the highly N doped layer L1.

This second step can be done by means of an etching technique such as the reactive ion etching (or RIE). But other etching techniques may be used, and notably the ion beam etching (or IBE), the inductive coupled plasma etching (or ICPE) and the dry etching.

A third step comprises growing a semi-insulating layer L5 on the free parts of the semi-insulating substrate SIS and on each ground area GAi and around each etched vertical structure VS'i. This growth is done up to the level of the top of each etched vertical structure VS'i. The semi-insulating layer L5 is preferably made of the same material as the semi-insulating substrate SIS.

This third step (which is a regrowth) can be done by means of an epitaxy.

A fourth step comprises growing a highly P doped layer L6 on the semi-insulating layer L6 and on top of each etched vertical structure VS'i.

In the case where the semi-insulating substrate SIS is made of InP, the highly P doped layer L6 can be also made of InP (InP-P+).

This fourth step (which is a regrowth) can be done by means of an epitaxy.

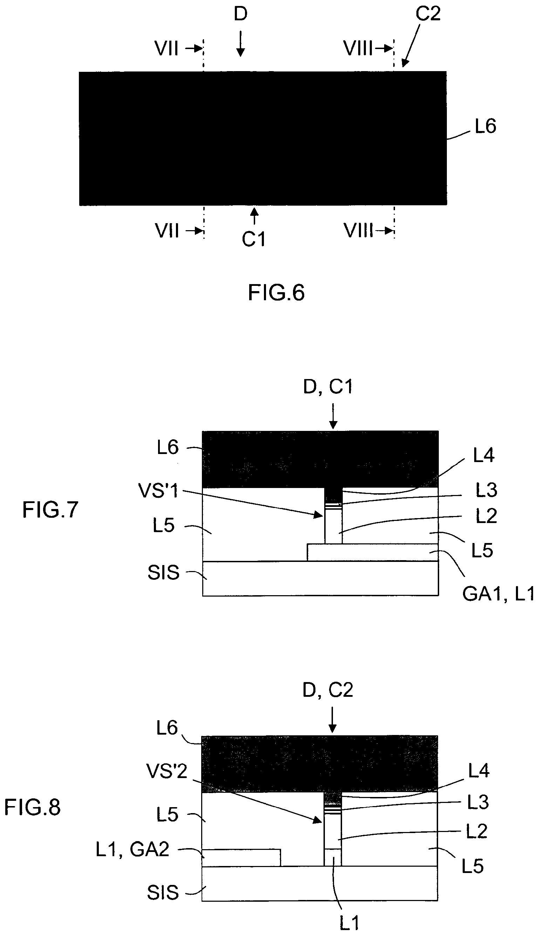

The result of the implementation of the third and fourth steps is illustrated in figures 6-8.

A fifth step comprises etching around each etched vertical structure VS'i till the level of the highly N doped layer L1, in order to define mesa strips constituting the active components Ci and to clear the top of each part of the highly N doped layer L1 that defines a ground area GAi associated to a mesa strip. This fifth step can be done by means of an etching technique such as the reactive ion etching (or RIE). But other etching techniques may be used, and notably the ion beam etching (or IBE), the inductive coupled plasma etching (or ICPE) and the dry etching.

It is important to note that before proceeding to this last etching, one may deposit a contact layer on top of each part of the highly P doped layer L6 that is set on top of an etched vertical structure VS'i, in order to fully or partly define an integrated control electrode Ei1 associated to the active component Ci that is constituted by this etched vertical structure VS'i. But, this deposition could be done during the sixth step.

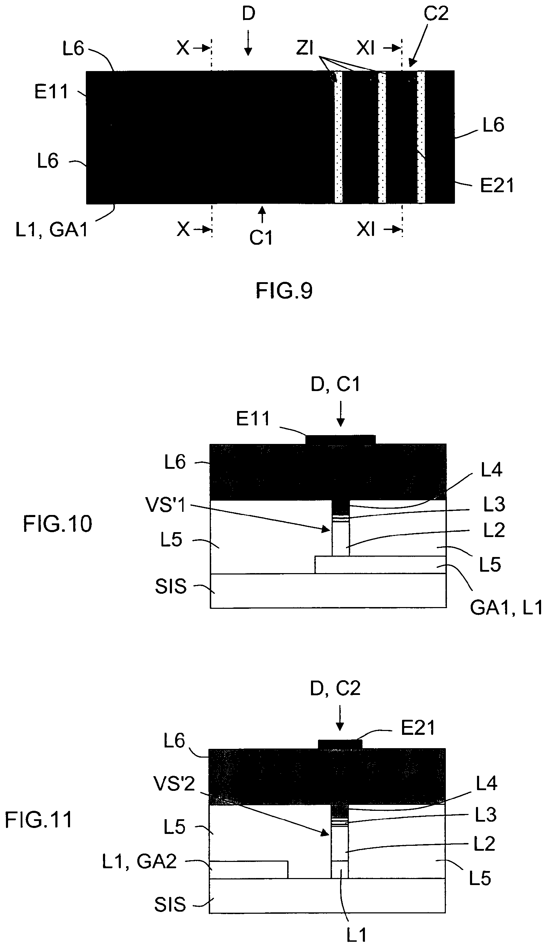

As illustrated in figures 9-11, in the case where the components to define are a laser C1 and a modulator C2, a first integrated control electrode E11 is deposited on top of the first mesa strip defining the laser C1, and a second integrated control electrode E21 is deposited on top of the second mesa strip defining the modulator C2.

Moreover, in the case where the device D comprises at least two etched vertical structures VS'i, it is advantageous to proceed to a local electrical isolation of the etched vertical structures VS'i before proceeding to the last etching of the fifth step. This aims at rendering the active components Ci electrically independent one from the other to avoid electrical cross talk (like leakage current and parasitic capacitance).

The local isolation is represented by the rectangles referenced ZI, that are set on top of the highly P doped layer L6 in figure 9. In the illustrated example, three isolation zones ZI have been created, a first one being located just after the end of the first integrated control electrode E11 in a transversal position, and second and third ones being respectively located just before and just after the second integrated control electrode E21 in transversal positions.

This local electrical isolation can be carried out into the highly P doped layer L6 by means of a proton implantation in a part of at least each area that is located between two etched vertical structures VS'i. Such a proton implantation can be done by means of an accelerator of particles or a plasma generator.

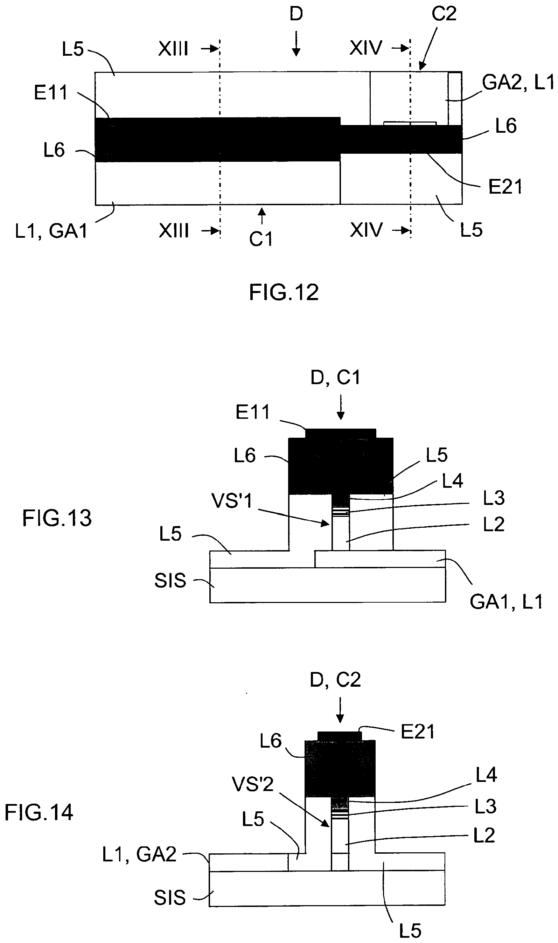

The result of the implementation of the fifth step (including the intermediate deposit and the intermediate isolation) is illustrated in figures 12-14.

A sixth step comprises depositing a contact layer on top of a part of each ground area GAi to define integrated ground electrodes Ei2, and at least a part of another contact layer on top of a part of each mesa strip to fully or partly define integrated control electrodes Ei1. Each integrated ground electrode Ei2 and its associated integrated control electrode Ei1 are intended to allow control of the corresponding active component Ci that is constituted by a mesa strip.

It must be understood that, in the case where contact layers have been previously deposited on top of a part of each mesa strip during the fifth step to partly define the integrated control electrodes Ei1, the latter are only completed during the sixth step. But, in the case where contact layers have not been previously deposited on top of a part of each mesa strip during the fifth step, then they may be deposited during the sixth step to fully define the integrated control electrodes Ei1. Finally, in the case where contact layers have been previously deposit on top of a part of each mesa strip during the fifth step to fully define the integrated control electrodes Ei1, the sixth step aims only at defining the integrated ground electrodes Ei2.

In the illustrated example, the integrated ground electrode E12 of the first component C1 (here a laser) is formed out of the mesa strip area to avoid parasitic capacitance (such as "fringe" capacitance) and leakage current for each component Ci.

Moreover, for a reverse bias component (such as a modulator or a photodetector), a large integrated ground electrode Ei2 is also formed out of its mesa strip. Thus, inside this active device-section, the electric field is applied only in the waveguide buried structure (layer L3) between the P-type layer L4 and the N-type layer L2 which is connected to the "ground ridge" part of layer L1 that is under the etched vertical structure VS'2. Thus, the device capacitance comes mainly from the ridge heterostructure (like in the Diode Ridge Technology), and the parasitic capacitance produced by the SIBH material is strongly reduced.

Preferably the device according to embodiments proposed herein has a structure such that the ground electrode is located at a position which is not opposite to the position of the control electrode but the ground electrode is located on the structure of the device at a position which is offset from a position directly opposite to a position of the control electrode on the structure of the device. Namely, considering a device having various sides including a bottom side and a top side, if a ground electrode is located at a particular location on the bottom side of the device, the control electrode is either not on the upper side (for example it may be on a lateral side) or if it is on the top side it is located at a location which is substantially away from a location (on the top side) facing the ground electrode. In this manner the two electrodes do not face each other on the structure of the device. Thus the notion of being "offset from a position directly opposite to a position of the control electrode" in the context of the present specification is to be understood as being displaced or shifted from the position directly opposite to the position of the control electrode. The advantage of such condition on the structure of the device is that of avoiding or substantially reducing parasitic capacitance.

It is important to note that, before defining at least the integrated ground electrodes Ei2, it is advantageous to grow an insulation (and possibly passivation) layer L7 on top of each cleared part of the highly N doped layer L1 that is located on a side of a mesa strip.

For instance, the insulation (and possibly passivation) layer L7 can be made of a benzo-cyclo-butene (BCB) polymer.

Such an insulation (and possibly passivation) layer L7 further allows to increase the size of the integrated control electrodes Ei1 that are partly defined during the fifth step.

The result of the implementation of this sixth step is illustrated in figures 15-17.

The invention is not limited to the embodiments of method and device described above, only as examples, but it encompasses all alternative embodiments which may be considered by one skilled in the art within the scope of the claims hereafter.

## Claims

1. A device comprising at least a first active optoelectronic component (Ci) and a second active optoelectronic component (Ci), said first and second active components being monolithically integrated onto a semi-insulating substrate (SIS), said device further comprising at least a first electrode arrangement (Eij) configured for controlling said first active optoelectronic component (Ci) by means of a control current or a control voltage and a second electrode arrangement (Eij) configured for controlling said second active optoelectronic component (Ci) by means of a control current or a control voltage, wherein each of the first control arrangement and the second control arrangement has a respective control electrode and a respective ground electrode,
wherein the first active optoelectronic component (Ci) comprises a first vertical structure (VS'i) and the second active optoelectronic component (Ci) comprises a second vertical structure (VS'i), wherein the first vertical structure (VS'i) and the second vertical structure (VS'i) are isolated from each other by isolation zones such that a first isolation zone (ZI) is on one side of a control electrode and a second isolation zone (ZI) is on another side of the control electrode, opposite the side of the first isolation zone (ZI).

2. A device according to claim 1, **characterized in that** each active optoelectronic component (Ci) is a semi-insulating buried heterostructure.

3. A device according to one of claims 1 and 2, **characterized in that** the substrate is an Indium Phosphide semi-insulating substrate (SIS) or a semi-insulating substrate (SIL).

4. A device according to any one of preceding claims comprising at least one integrated active optoelectronic component chosen from a group comprising at least a laser, a modulator, a photodetector or an amplifier.

5. A device according to any one of preceding claims wherein the ground electrode is located on the structure of the device at a position which is offset from a position directly opposite to a position of the control electrode on the structure of the device.

6. A method of manufacturing at least two active optoelectronic components (Ci) onto a semi-insulating substrate (SIS), wherein the manufacturing of a first and second active optoelectronic components comprises the steps of:
- growing a highly N doped layer (L1) on said semi-insulating substrate (SIS), and then layers (L2-L4) defining a vertical structure (VS) on said highly N doped layer (L1),
- etching said vertical structure (VS) to define at least one etched vertical structure (VS'i) set on top of a remaining part of said highly N doped layer (L1) and an associated ground area (GAi) also with a remaining part of said highly N doped layer (L1),
- growing a semi-insulating layer (L5) on said semi-insulating substrate (SIS) and on each ground area (GAi) and around each etched vertical structure (VS'i),
- growing a highly P doped layer (L6) on said semi-insulating layer (L6) and on top of each etched vertical structure (VS'i),
- etching around each etched vertical structure (VS'i) till the level of said highly N doped layer (L1) to define a mesa strip constituting an active optoelectronic component (Ci) and to clear the top of each part of said highly N doped layer (L1) defining a ground area (GAi) associated to said mesa strip, and
- depositing a contact layer on top of a part of each ground area (GAi) to define an integrated ground electrode (Ei2) and at least a part of another contact layer on top of a part of each mesa strip to define an integrated control electrode (Ei1) configured for allowing control of the active optoelectronic component (Ci) constituted by said mesa strip;
wherein the first active optoelectronic component (Ci) comprises a first etched vertical structure (VS'i) and the second active optoelectronic component (Ci) comprises a second etched vertical structure (VS'i), wherein the first etched vertical structure (VS'i) and the second etched vertical structure (VS'i) are isolated from each other by isolation zones such that a first isolation zone (ZI) is on one side of a control electrode and a second isolation zone (ZI) is on another side of the control electrode, opposite the side of the first isolation zone (ZI).

7. Method according to claim 6, **characterized by** depositing a contact layer on top of each part of said highly P doped layer (L6) set on top of an etched vertical structure (VS'i), to define at least a part of said integrated control electrode (Ei1) associated to the active optoelectronic component constituted by said etched vertical structure (VS'i), before etching around each etched vertical structure (VS'i).

8. Method according to claim 6, **characterized by** depositing said other contact layer on top of a part of each mesa strip to fully define said integrated control electrode (Ei1).

9. Method according to one of claims 6 to 8, **characterized by** growing an insulation layer (L7) on top of each cleared part of said highly N doped layer (L1) that is located on a side of a mesa strip, before defining at least each associated integrated ground electrode (Ei2).

10. Method according to claim 9, **characterized in that** said insulation layer (L7) is a benzo-cyclo-butene polymer.

11. Method according to one of claims 6 to 10, **characterized by** using an etching technique chosen from a group comprising at least reactive ion etching, ion beam etching, inductive coupled plasma etching and dry etching.

## Patentansprüche

1. Vorrichtung, die mindestens eine erste aktive optoelektronische Komponente (Ci) und eine zweite aktive optoelektronische Komponente (Ci) umfasst, wobei die ersten und zweiten aktiven Komponenten monolithisch auf einem halbisolierenden Substrat (Semi-Insulating Substrate - SIS) integriert sind, wobei die Vorrichtung ferner mindestens eine erste Elektrodenanordnung (Eij), die dazu ausgestaltet ist, die erste aktive optoelektronische Komponente (Ci) mittels eines Steuerstroms oder einer Steuerspannung zu steuern, und eine zweite Elektrodenanordnung (Eij) umfasst, die dazu ausgestaltet ist, die zweite aktive optoelektronische Komponente (Ci) mittels eines Steuerstroms oder einer Steuerspannung zu steuern, wobei jede von der ersten Steueranordnung und der zweiten Steueranordnung eine entsprechende Steuerelektrode und eine entsprechende Masseelektrode aufweist, wobei die erste aktive optoelektronische Komponente (Ci) eine erste vertikale Struktur (VS'i) umfasst und die zweite aktive optoelektronische Komponente (Ci) eine zweite vertikale Struktur (VS'i) umfasst, wobei die erste vertikale Struktur (VS'i) und die zweite vertikale Struktur (VS'i) derart durch Isolationszonen voneinander isoliert sind, dass eine erste Isolationszone (ZI) sich auf einer Seite einer Steuerelektrode befindet und eine zweite Isolationszone (ZI) sich auf einer anderen Seite der Steuerelektrode befindet, die der Seite der ersten Isolationszone (ZI) entgegengesetzt ist.

2. Vorrichtung nach Anspruch 1, **dadurch gekennzeichnet, dass** jede aktive optoelektronische Komponente (Ci) eine halbisolierende vergrabene Heterostruktur ist.

3. Vorrichtung nach einem der Ansprüche 1 und 2, **dadurch gekennzeichnet, dass** das Substrat ein halbisolierendes Indiumphosphidsubstrat (SIS) oder ein halbisolierendes Substrat (SIL) ist.

4. Vorrichtung nach einem der vorhergehenden Ansprüche, die mindestens eine integrierte aktive optoelektronische Komponente umfasst, die aus einer Gruppe ausgewählt ist, die mindestens einen Laser, einen Modulator, einen Fotodetektor oder einen Verstärker umfasst.

5. Vorrichtung nach einem der vorhergehenden Ansprüche, wobei die Masseelektrode sich auf der Struktur der Vorrichtung an einer Position befindet, die von einer Position versetzt ist, die einer Position der Steuerelektrode auf der Struktur der Vorrichtung direkt entgegengesetzt ist.

6. Verfahren zur Herstellung von mindestens zwei aktiven optoelektronischen Komponenten (Ci) auf einem halbisolierenden Substrat (SIS), wobei die Herstellung einer ersten und zweiten aktiven optoelektronischen Komponente die folgenden Schritte umfasst:
- Züchten einer hoch n-dotierten Schicht (L1) auf dem halbisolierenden Substrat (SIS) und dann von Schichten (L2 bis L4), die eine vertikale Struktur (VS) auf der hoch n-dotierten Schicht (L1) definieren,
- Ätzen der vertikalen Struktur (VS), um mindestens eine geätzte vertikale Struktur (VS'i), die auf dem Oberteil eines übrigen Teils der hoch n-dotierten Schicht (L1) eingestellt ist, und einen zugehörigen Massebereich (GAi) auch mit einem übrigen Teil der hoch n-dotierten Schicht (L1) zu definieren,
- Züchten einer halbisolierenden Schicht (L5) auf dem halbisolierenden Substrat (SIS) und auf jedem Massebereich (GAi) und um jede geätzte vertikale Struktur (VS'i),
- Züchten einer hoch p-dotierten Schicht (L6) auf der halbisolierenden Schicht (L6) und auf dem Oberteil jeder geätzten vertikalen Struktur (VS'i),
- Ätzen um jede geätzte vertikale Struktur (VS'i) bis zum Niveau der hoch n-dotierten Schicht (L1), um einen Mesa-Streifen zu definieren, der eine aktive optoelektronische Komponente (Ci) bildet, und um den Oberteil von jedem Teil der hoch n-dotierten Schicht (L1) freizumachen, wodurch ein Massebereich (GAi) definiert wird, der dem Mesa-Streifen zugehörig ist, und
- Abscheiden einer Kontaktschicht auf dem Oberteil eines Teils von jedem Massebereich (GAi), um eine integrierte Masseelektrode (Ei2) zu definieren, und mindestens eines Teils einer anderen Kontaktschicht auf dem Oberteil eines Teils von jedem Mesa-Streifen, um eine integrierte Steuerelektrode (Ei1) zu definieren, die dazu ausgestaltet ist, die Steuerung der aktiven optoelektronischen Komponente (Ci) zu ermöglichen, die durch den Mesa-Streifen gebildet ist;
wobei die erste aktive optoelektronische Komponente (Ci) eine erste geätzte vertikale Struktur (VS'i) umfasst und die zweite aktive optoelektronische Komponente (Ci) eine zweite geätzte vertikale Struktur (VS'i) umfasst, wobei die erste geätzte vertikale Struktur (VS'i) und die zweite geätzte vertikale Struktur (VS'i) derart voneinander durch Isolationszonen isoliert sind, dass eine erste Isolationszone (ZI) sich auf einer Seite einer Steuerelektrode befindet und eine zweite Isolationszone (ZI) sich auf einer anderen Seite der Steuerelektrode befindet, die der Seite der ersten Isolationszone (ZI) entgegengesetzt ist.

7. Verfahren nach Anspruch 6, **gekennzeichnet durch** Abscheiden einer Kontaktschicht auf dem Oberteil von jedem Teil der hoch p-dotierten Schicht (L6), die auf dem Oberteil einer geätzten vertikalen Struktur (VS'i) eingestellt ist, um mindestens einen Teil der integrierten Steuerelektrode (Ei1) zu definieren, die der aktiven optoelektronischen Komponente zugehörig ist, die aus der geätzten vertikalen Struktur (VS'i) besteht, vor dem Ätzen um jede geätzte vertikale Struktur (VS'i).

8. Verfahren nach Anspruch 6, **gekennzeichnet durch** Abscheiden der anderen Kontaktschicht auf dem Oberteil eines Teils von jedem Mesa-Streifen, um die integrierte Steuerelektrode (Ei1) vollständig zu definieren.

9. Verfahren nach einem der Ansprüche 6 bis 8, **gekennzeichnet durch** Züchten einer Isolationsschicht (L7) auf dem Oberteil von jedem freigemachten Teil der hoch n-dotierten Schicht (L1), die sich auf einer Seite eines Mesa-Streifens befindet, vor dem Definieren von mindestens jeder zugehörigen integrierten Masseelektrode (Ei2).

10. Verfahren nach Anspruch 9, **dadurch gekennzeichnet, dass** die Isolationsschicht (L7) ein Benzocyclobuten-Polymer ist.

11. Verfahren nach einem der Ansprüche 6 bis 10, **gekennzeichnet durch** das Verwenden einer Ätztechnik, die ausgewählt ist aus einer Gruppe, die mindestens reaktives Ionenätzen, Ionenstrahlätzen, induktives gekoppeltes Plasmaätzen und Trockenätzen umfasst.

## Revendications

1. Dispositif comprenant au moins un premier composant optoélectronique actif (Ci) et un deuxième composant optoélectronique actif (Ci), lesdits premier et deuxième composants actifs étant intégrés de manière monolithique sur un substrat semi-isolant (SIS), ledit dispositif comprenant en outre au moins un premier agencement d'électrodes (Eij) configuré pour commander ledit premier composant optoélectronique actif (Ci) au moyen d'un courant de commande ou d'une tension de commande et un deuxième agencement d'électrodes (Eij) configuré pour commander ledit deuxième composant optoélectronique actif (Ci) au moyen d'un courant de commande ou d'une tension de commande, dans lequel chacun parmi le premier agencement de commande et le deuxième agencement de commande a une électrode de commande respective et une électrode de masse respective, dans lequel le premier composant optoélectronique actif (Ci) comprend une première structure verticale (VS'i) et le deuxième composant électronique actif (Ci) comprend une deuxième structure verticale (VS'i), dans lequel la première structure verticale (VS'i) et la deuxième structure verticale (VS'i) sont isolées l'une de l'autre par des zones d'isolation de façon qu'une première zone d'isolation (ZI) soit sur un côté d'une électrode de commande et qu'une deuxième zone d'isolation (ZI) soit sur un autre côté de l'électrode de commande, opposé au côté de la première zone d'isolation (ZI).

2. Dispositif selon la revendication 1, **caractérisé en ce que** chaque composant optoélectronique actif (Ci) est une structure hétérogène enfouie semi-isolante.

3. Dispositif selon l'une des revendications 1 et 2, **caractérisé en ce que** le substrat est un substrat semi-isolant en phosphure d'indium (SIS) ou un substrat semi-isolant (SIL).

4. Dispositif selon l'une quelconque des revendications précédentes, comprenant au moins un composant optoélectronique actif intégré choisi dans le groupe comprenant au moins un laser, un modulateur, un photodétecteur et un amplificateur.

5. Dispositif selon l'une quelconque des revendications précédentes, dans lequel l'électrode de masse est située sur la structure du dispositif à une position qui est décalée par rapport à une position directement opposée à une position de l'électrode de commande sur la structure du dispositif.

6. Procédé de fabrication d'au moins deux composants optoélectroniques actifs (Ci) sur un substrat semi-isolant (SIS), dans lequel la fabrication d'un premier et d'un deuxième composants optoélectroniques actifs comprend les étapes de :
- croissance d'une couche fortement N-dopée (L1) sur ledit substrat semi-isolant (SIS), et ensuite de couches (L2-L4) définissant une structure verticale (VS) sur ladite couche fortement N-dopée (L1),
- gravure de ladite structure verticale (VS) pour définir au moins une structure verticale gravée (VS'i) établie sur le dessus d'une partie restante de ladite couche fortement N-dopée (L1) et une zone de masse associée (GAi) également avec une partie restante de ladite couche fortement N-dopée (L1),
- croissance d'une couche semi-isolante (L5) sur ledit substrat semi-isolant (SIS) et sur chaque zone de masse (GAi) et autour de chaque structure verticale gravée (VS'i),
- croissance d'une couche fortement P-dopée (L6) sur ladite couche semi-isolante (L6) et sur le dessus de chaque structure verticale gravée (VS'i),
- gravure autour de chaque structure verticale gravée (VS'i) jusqu'au niveau de ladite couche fortement N-dopée (L1) pour définir une bande mesa constituant un composant optoélectronique actif (Ci) et pour dégager le haut de chaque partie de ladite couche fortement N-dopée (L1) définissant une zone de masse (GAi) associée à ladite bande mesa, et
- dépôt d'une couche de contact sur le dessus d'une partie de chaque zone de masse (GAi) pour définir une électrode de masse intégrée (Ei2) et d'au moins une partie d'une autre couche de contact sur le dessus d'une partie de chaque bande mesa pour définir une électrode de commande intégrée (Ei1) configurée pour permettre la commande du composant optoélectronique actif (Ci) constitué de ladite bande mesa ;
dans lequel le premier composant optoélectronique actif (Ci) comprend une première structure verticale gravée (VS'i) et le deuxième composant électronique actif (Ci) comprend une deuxième structure verticale gravée (VS'i), dans lequel la première structure verticale gravée (VS'i) et la deuxième structure verticale gravée (VS'i) sont isolées l'une de l'autre par des zones d'isolation de façon qu'une première zone d'isolation (ZI) soit sur un côté d'une électrode de commande et qu'une deuxième zone d'isolation (ZI) soit sur un autre côté de l'électrode de commande, opposé au côté de la première zone d'isolation (ZI).

7. Procédé selon la revendication 6, **caractérisé par** le dépôt d'une couche de contact sur le dessus de chaque partie de ladite couche fortement P-dopée (L6) établie sur le dessus d'une structure verticale gravée (VS'i), pour définir au moins une partie de ladite électrode de commande intégrée (Ei1) associée au composant optoélectronique actif constitué de ladite structure verticale gravée (VS'i) avant une gravure autour de chaque structure verticale gravée (VS'i).

8. Procédé selon la revendication 6, **caractérisé par** le dépôt de ladite autre couche de contact sur le dessus d'une partie de chaque bande mesa pour définir complètement ladite électrode de commande intégrée (Ei1).

9. Procédé selon l'une des revendications 6 à 8, **caractérisé par** la croissance d'une couche d'isolation (L7) sur le dessus de chaque partie dégagée de ladite couche fortement N-dopée (L1) qui est située sur un côté d'une bande mesa, avant la définition d'au moins chaque électrode de masse intégrée associée (Ei2).

10. Procédé selon la revendication 9, **caractérisé en ce que** ladite couche d'isolation (L7) est un polymère de benzocyclobutène.

11. Procédé selon l'une des revendications 6 à 10, **caractérisé par** l'utilisation d'une technique de gravure choisie dans le groupe comprenant au moins une gravure ionique réactive, une gravure par faisceau ionique, une gravure par plasma couplé inductif, et une gravure à sec.
